# EUROPEAN PATENT APPLICATION

(11) **EP 4 160 196 A1**
(43) Date of publication of application: **05.04.2023**
(21) Application number: 22198137.6
(22) Date of filing: 27.09.2022
(51) Int. Cl.: G01N 23/2208, G01N 23/2252, G01N 23/2255

(54) **METHODS AND SYSTEMS FOR ELEMENTAL MAPPING**

(30) Priority: 30.09.2021 US 202117490412
(71) Applicant: FEI Company, Hillsboro, OR 97124-5793 (US)
(72) Inventor: BUDNIK, Garrett, Hillsboro, 97124 - 5793 (US); JIAO, Chengge, Hillsboro, 97124 - 5793 (US); MAAZOUZ, Mostafa, Hillsboro, 97124 - 5793 (US); OFFICER, Suzanna, Hillsboro, 97124 - 5793 (US); GLEDHILL, Galen, Hillsboro, 97124 - 5793 (US); RUE, Chad, Hillsboro, 97124 - 5793 (US)
(74) Representative: Boult Wade Tennant LLP

(57) **Abstract**

Methods and systems for imaging a sample with a charged particle microscope comprises after scanning a region of interest (ROI) of a sample with an electron beam and acquiring X-rays emitted from the sample, scanning the ROI with an ion beam and acquiring ion-induced photons emitted from the sample. A spatial distribution of multiple elements in the sample may be determined based on both the acquired X-rays and the acquired ion-induced photons.

## Description

### FIELD OF THE INVENTION

The present description relates generally to methods and systems for determining sample composition, and more particularly, to mapping elements in the sample using a charged particle microscope.

### BACKGROUND OF THE INVENTION

Charged particle microscopy is a well-known and increasingly important technique for imaging microscopic objects. Multiple types of emissions from a sample responsive to charged particle irradiation may provide structural and compositional information of the sample. For example, based on energy spectrum of an X-ray emission responsive to electron beam irradiation, energy-dispersive X-ray spectroscopy (EDS or EDX) can be used for elemental analysis or chemical characterization. However, Applicant recognizes that some of the light elements are hard or impossible to be detected with EDS.

### SUMMARY

In one embodiment, a method comprises scanning a region of interest (ROI) of a sample with an electron beam and acquiring X-rays emitted from the sample; after scanning the ROI with the electron beam, scanning the ROI with an ion beam and acquiring ion-induced photons emitted from the sample; and determining a spatial distribution of multiple elements in the sample based on both the acquired X-rays and the acquired ion-induced photons. In this way, spatial distribution of elements that cannot be detected by EDS may be mapped based on ion beam induced light emission.

In another embodiment, a charged particle microscopy system for determining composition of a sample comprises an ion source for generating an ion beam; an electron source for generating an electron beam; a first detector for detecting X-rays emitted from a sample; a second detector for detecting ion-induced photons emitted from the sample; and a controller including a non-transitory memory for storing computer readable instructions, wherein by executing the instructions, the controller is configured to: scan a region of interest (ROI) of the sample with the electron beam and acquire X-rays emitted from the sample using the first detector; after scanning the ROI with the electron beam, scan the ROI with the ion beam and acquire ion-induced photons emitted from the sample using the second detector; and determine a spatial distribution of multiple elements in the sample based on both the acquired X-rays and the acquired ion-induced photons. In one example, the second detector is retractable from an imaging position at which the ion beam induced light emission is detected.

It should be understood that the summary above is provided to introduce in simplified form a selection of concepts that are further described in the detailed description. It is not meant to identify key or essential features of the claimed subject matter, the scope of which is defined uniquely by the claims that follow the detailed description. Furthermore, the claimed subject matter is not limited to implementations that solve any disadvantages noted above or in any part of this disclosure.

### BRIEF DESCRIPTION OF THE DRAWINGS

FIG. 1 illustrates a charged particle microscope for elemental mapping, according to some embodiments.
FIG. 2A shows a distal end of a light collection system for detecting ion induced light.
FIG. 2B shows the light collection system of FIG. 2A in a vacuum chamber of the microscope of FIG. 1.
FIG. 3 is a flowchart of an example method for elemental mapping.
FIG. 4 shows a method for optimizing parameters for the ion beam scan.
FIG. 5 shows an example calibration table generated using the method of FIG. 4.
FIG. 6 is an example method for performing the ion beam scan.
FIGS. 7A and 7B show example optical spectra acquired using heavy and light ions, respectively.
FIG. 8A is an image generated from ion beam induced light after implanting the sample with light ions.
FIG. 8B is an integrated spectrum of FIG. 8A.
FIGS. 9A and 9B show amplitudes of the ion beam induced light change over time when using heavy and light ions, respectively.
FIGS. 9C and 9D are SEM images showing a sample after scanning the sample with heavy and light ions, respectively.
FIG. 10 illustrates a sample analyzed using the method of FIG. 3.
FIG. 11A is a SEM image of a cross-section of a sample.
FIGS. 11B and 11D are EDS images of the same sample cross-section as in FIG. 11A.
FIGS. 11C and 11E are ion beam induced light images of the same sample cross-section as in FIG. 11A.
FIGS. 12A and 12B are respectively FIB-SE image and ion-induced photon image of a cross-section of a sample.
FIGS. 12C and 12D are integrated spectra in different regions of FIG. 12B.
FIG. 13 is a collage of SEM image and EDS images of a battery sample.
FIGS. 14A, 14B, 14C and 14D are respectively ion beam induced light images of Ni, Fe, Al, and Li of the battery sample of FIG. 13.

Like reference numerals refer to corresponding parts throughout the several views of the drawings.

### DETAILED DESCRIPTION

The following description relates to systems and methods for determining composition of a sample. Sample composition may be determined via charged particle based spectroscopic techniques such as energy-dispersive X-ray spectroscopy (EDS or EDX) and secondary ion mass microscopy (SIMS). These spectroscopic techniques can be combined with scanning electron microscopy (SEM) or transmission electron microscopy (TEM) to provide co-registered compositional and structural information of the sample. However, some elements, especially light elements (i.e. element with atomic number not greater than 11), are hard or impossible to be detected by EDS or SIMS. For example, hydrogen cannot be detected by EDS, and is difficult to be detected by SIMS. EDS has low sensitivity to alkali metal such as lithium, and also to trace metal/element. Because understanding the spatial distribution of elements including H and Li may be critical for manufacturing and evaluating certain sample, such as the battery sample, there is a need for obtaining a complete elemental map of the sample. Further, SEM based techniques have difficulty to detect trace elements due to their large interaction volume, resolution limits, and lack of surface sensitivity.

Applicant recognizes that comparing to EDS and SIMS, ion beam induced light emission is more sensitive to heavy elements, alkali metal, and trace element. By scanning the sample with the electron beam before the ion beam, both X-ray emission and photon emission from the sample can be acquired. By combining information obtained from ion beam induced light emission with EDS, a complete elemental mapping of the sample may be generated.

In one example, a region of interest (ROI) of the sample is first scanned with an electron beam, and X-rays emitted from the sample are acquired. Then, the ROI is scanned with an ion beam, and photon emissions from the sample are acquired. Elements within the ROI of the sample surface may be determined by analyzing the acquired X-ray and optical spectra. Due to different sensitivities of the EDS and the ion beam induced light emission to different elements, more elements may be identified and mapped by combing the EDS with ion beam induced light emission. For example, the EDS detects elements with atomic number greater than 11 and the ion beam induced light emission detects elements with atomic number not greater than 11. The ion beam induced light emission detects alkali metal while the EDS detects non-alkali metal. The EDS detects an element at a higher weight concentration, while the ion beam induced light emission detects the element at a lower weight concentration. For example, the FIB-iLE may detect some element with a weight concentration lower than 100 ppm. The detection limit of the FIB-iLE is element dependent.

In some examples, the ion beam is a focused ion beam (FIB), and the ion beam induced light emission is herein also referred to as focused ion beam induced light emission (FIB-iLE). Due to the destructive nature of the ion beam scan, the sample surface is first scanned with the electron beam before being scanned with the ion beam, so that the same sample layer is analyzed by both EDS and FIB-iLE. Because the interaction volume of the electron beam with the sample is generally greater than the interaction volume of the ion beam, at each scan location, EDS signals may include information of a larger sample volume than the FIB-iLE signals. Therefore, the FIB-iLE imaging can achieve a higher resolution than the EDS imaging.

In one example, elemental composition of a first sample layer is determined based on signals acquired during the electron beam scan and the ion beam scan of a first sample surface. While scanning the first sample surface with the ion beam, the first sample surface is milled by the ion beam to expose a second sample surface at an increased sample depth. The second sample surface is scanned using the electron beam and the ion beam, and the elemental composition of the second sample surface is determined. The above procedures may be repeated for multiple iterations to reconstruct a three-dimensional elemental composition of the sample.

In some examples, one or more elemental maps showing distribution of multiple elements are generated based on the acquired X-rays and photon emissions. Spatial distribution of the multiple elements can be shown in a single elemental map by color-coding each element.

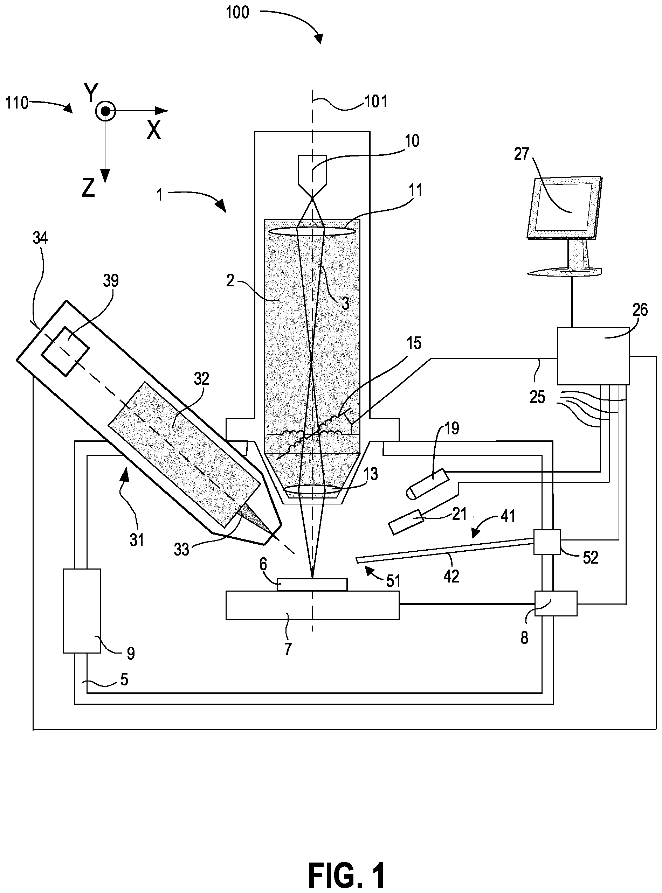

The combined EDS and FIB-iLE sample analysis may be performed in a charged particle microscope (CPM) shown in FIG. 1. The CPM includes an ion source and an electron source for generating a FIB and a focused electron beam, respectively. The CPM includes a first detector (such as EDS detector) for detecting the X-rays emitted from the sample responsive to the electron beam irradiation and a second detector (such as FIB-iLE detector) for detecting ion-induced photons emitted from the sample responsive to the FIB irradiation.

In one example, the ion source is a liquid metal ion source (LMIS). In another example, the ion source is a plasma ion source capable of generating a focused ion beam of one or more gas species. Signal strength for FIB-iLE may be enhanced by adjusting the gas chemistry of the plasma ion beam. In one embodiment, scanning the ROI with the ion beam includes simultaneously directing ions of at least two species towards the sample surface. One of the at least two ion species may be lighter and more chemically active than the other ion species. In one example, the atomic number difference between the at least two ion species may be not less than 8. In another example, the atomic number difference between the at least two ion species may be not less than 10. The lighter ions (i.e. ions with lower atomic number) has a higher photon yield for FIB-iLE, while the heavier ions (i.e. ions with higher atomic number) has a higher sputter rate. By scanning the ROI with both the lighter ions and the heavier ions, the FIB-iLE signal is enhanced and at the same time, sample can be removed at high sputter rate. In another embodiment, scanning the ROI with the ion beam including first scanning selected regions within the ROI with a lighter ion to implant the lighter ion in the sample, and then scanning the ROI with a heavier ion for FIB-iLE signal acquisition. By implanting the lighter, chemically active ion, in selected regions within the ROI, the photon yield in these selected regions during the following ion beam scan with the heavier, inert ion, can be enhanced.

The second, FIB-iLE, detector may include a light collection system retractable from the vacuum chamber within which the sample is imaged. The light collection system may include an optical fiber with a first distal end enclosed in an elongated sheath. A lens is optically coupled to the first distal end of the optical fiber for directly collecting photons emitted from the sample. The lens is mechanically coupled to the sheath. Light emitted from the sample is collected by the FIB-iLE detector when the detector is positioned at an imaging position, wherein the first distal end of the detector is positioned between a pole piece (either the pole piece of the ion column or the electron column) and the sample. The FIB-iLE detector may be inserted to the imaging position and/or retracted from the imaging position via a flange on the vacuum chamber of the charged particle microscope. Due to the compact profile of the FIB-iLE detector, alternating EDS and FIB-iLE sample scan may be performed without retracting the FIB-iLE detector from the imaging position. In some examples, the FIB-iLE detector may be retracted from the imaging position during sample maneuver and/or for detector maintenance.

The FIB-iLE detector may be used for detecting photon emission responsive to irradiations other than ion beam. For example, photon emissions responsive to electron beam or light irradiation can also be collected with the FIB-iLE detector. The FIB-iLE detector may be introduced into the vacuum chamber of a charged particle microscope compatible with a gas injection system (GIS), via the same flange for the GIS system. As such, photon detection can be achieved without significant system modification. The FIB-iLE detector may also be used for delivering light towards the sample.

In one example, a method for detecting photon emissions responsive to charged particle or photon irradiation using the FIB-iLE detector comprises: before pumping down a vacuum chamber within which the sample is positioned, inserting the light collection system of the FIB-iLE detector into the vacuum chamber via an opening on the vacuum chamber; pumping down the vacuum chamber; irradiating the sample with the charged particle beam or photons; and receiving photon emissions from the sample via the light collection system positioned at the imaging location. The status of the lens or lens system of the light collection system may be determined by monitoring the signal attenuation of the detected photons overtime. The lens or lens system may be replaced or cleaned after a period of use based on the status.

Turning to FIG. 1, FIG. 1 is a highly schematic depiction of an embodiment of a dual-beam charged particle microscope (CPM) in which the present invention is implemented; more specifically, it shows an embodiment of a FIB-SEM. Coordinate 110 is system coordinate. Microscope 100 comprises a particle-optical column 1, which produces a beam 3 of charged particles (in this case, an electron beam) that propagates along electron-optical axis 101. Electron-optical axis 101 may be aligned with the Z axis of the system. The column 1 is mounted on a vacuum chamber 5, which comprises a sample holder 7 and associated actuator(s) 8 for holding/positioning a sample 6. The vacuum chamber 5 is evacuated using vacuum pumps (not depicted). Also depicted is a vacuum port 9, which may be opened to introduce/remove items (components, samples) to/from the interior of vacuum chamber 5. Microscope 100 may comprise a plurality of such ports 9, if desired.

The electron column 1 comprises an electron source 10 and an illuminator 2. The illuminator 2 comprises lenses 11 and 13 to focus the electron beam 3 onto the sample 6, and a deflection unit 15 (to perform beam steering / scanning of the beam 3). The microscope 100 further comprises a controller / computer processing apparatus 26 for controlling inter alia the deflection unit 15, lenses 11, 13 and detectors 19, 21, and 41, and displaying information gathered from the detectors 19, 21, and 41 on a display unit 27.

The detectors 19, 21 may be chosen from a variety of possible detector types that can be used to examine different types of "stimulated" radiation emanating from the sample 6 in response to irradiation by the (impinging) electron beam 3. It could alternatively be an X-ray detector, such as Silicon Drift Detector (SDD) or Silicon Lithium (Si(Li)) detector, for example. Detector 21 may be an electron detector in the form of a Solid State Photomultiplier (SSPM) or evacuated Photomultiplier Tube (PMT) for example. This can be used to detect backscattered and/or secondary electrons emanating from the sample 6. Microscope 100 may also include an ion detector and a mass analyzer for SIMS imaging. The skilled artisan will understand that many different types of detector can be chosen in a set-up such as that depicted, including, for example, an annular/segmented detector.

Detector 41 includes a retractable light collection system 42 for detecting photon emissions from sample 6. The photon emissions may be resulted from ion and/or electron beam irradiation on the sample surface. The light collection system 42 may be introduced to the vacuum chamber 5 via flange 52 on the vacuum chamber 5. Photons collected by the first distal end 51 of the light collection system 42 may be converted and amplified by an imaging sensor before transferring to controller 26. In some embodiment, the light collection system may also be used to deliver light towards sample 6. Detector 41 is herein referred to as FIB-iLE detector for detecting light emission responsive to FIB irradiation. However, detector 41 can also be used for detecting cathodoluminescence resulted from electron beam irradiation.

By scanning the beam 3 over the sample 6, stimulated radiation - comprising, for example, X-rays, infrared/visible/ultraviolet light, secondary electrons (SEs) and/or backscattered electrons (BSEs) - emanates from the sample 6. Since such stimulated radiation is position-sensitive (due to said scanning motion), the information obtained from the detectors 19, 21 and 41 will also be position-dependent.

The signals from the detectors (19, 21 and 41) pass along control lines (buses) 25, are processed by the controller 26, and displayed on display unit 27. Such processing may include operations such as combining, integrating, subtracting, false coloring, edge enhancing, and other processing known to the skilled artisan. In addition, automated recognition processes (e.g. as used for particle analysis) may be included in such processing. The controller includes a non-transitory memory for storing computer readable instructions, and a processor for executing the computer readable instructions. Methods disclosed herein may be implemented by executing the computer readable instructions in the processor.

In addition to the electron column 1 described above, the microscope 100 also comprises an ion column 31. This comprises an ion source 39 and an illuminator 32, and these produce/direct a focused ion beam (FIB) 33 along an ion-optical axis 34. To facilitate easy access to sample 6 on holder 7, the ion-optical axis 34 is canted relative to the electron-optical axis 101. As hereabove described, such ion column 31 can, for example, be used to perform processing/machining operations on the sample 6, such as incising, milling, etching, depositing, etc. Additionally, the ion column 31 can be used to produce imagery of the sample 6. It should be noted that ion column 31 may be capable of generating various different species of ion; accordingly, references to ion beam 33 should not necessarily been seen as specifying a particular species in that beam at any given time - in other words, the ion beam 33 might comprise ion species A for operation A (such as milling) and ion species B for operation B (such as implanting), where species A and B can be selected from a variety of possible options.

The microscope may include a Gas Injection System (GIS), which can be used to effect localized injection of gases, such as etching or precursor gases, etc., for the purposes of performing gas-assisted etching or deposition. Such gases can be stored/buffered in a reservoir and can be administered through a narrow nozzle, so as to emerge in the vicinity of the intersection of axes 101 and 34, for example. The GIS system may be introduced to vacuum chamber 5 via the same flange 52 as for introducing detector 41.

It should be noted that many refinements and alternatives of such a set-up will be known to the skilled artisan, such as the use of a controlled environment within (a relatively large volume of) the microscope 100, e.g. maintaining a background pressure of several mbar (as used in an Environmental SEM or low-pressure SEM).

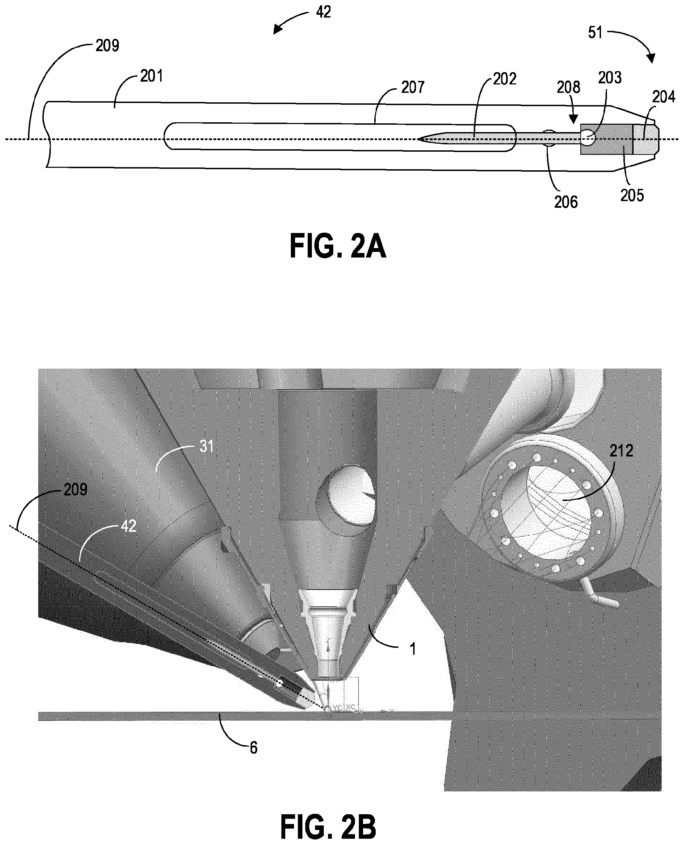

FIG. 2A is a closed-up view of the first distal end 51 of the light collection system 42 of detector 41 for detecting photons from a sample responsive to charged particle irradiation. The light collection system includes an optical fiber 202 with a first distal end 208 enclosed in an elongated sheath 201. The outer diameter of the sheath 201 is less than 4 mm. In this example, the first distal end 208 of the fiber enters the lumen of the sheath sideways via a channel 207. Channel 207 is not aligned with axis 209 and is fluidically connected with an opening of the sheath. Alternatively, the first distal tend of the fiber may enter the lumen via the second distal end of the light collection system along axis 209, so that the fiber is aligned with the axis 209. A lens 204 positioned at the first distal end 51 of the light collection system is optically coupled with the optical fiber 202. The lens 204 is mechanically coupled to the sheath 201. Lens 204 focuses light reaches the first distal end 51 of the light collection system to the first distal end 208 of the optical fiber 202. The lens 204 has a NA higher than 0.22for a large light collection angle. FIG. 2A shows a single lens 204. In some embodiments, lens 204 may be a lens system including multiple lenses. The multiple lenses may have the same outer diameter. In FIG. 2A, the first distal end 208 of the optical fiber 202 and the lens 204 are spaced apart with gap 205. The length of gap 205 along axis 209 depends on the focal length of lens 204. Opening 203 on the sheath provides fluidic connection between gap 205 and the external of the light detection system. As such, gas in gap 205 may be removed from the light detection system while pumping down the vacuum chamber. The axial position of the first distal end 208 relative to the axis 209 may be adjusted with one or more set screws through one or more holes 206 for optimized light coupling between the fiber and the lens. In other examples, the lens or lens system can be directly fused onto the distal end 208 of the optical fiber.

In one example, the outer diameter of lens 204 matches the inner diameter of the sheath 201, so that the lens can be inserted into the lumen of the sheath 201. The outer diameter of the sheath 201 is greater than the outer diameter of the lens. At least a part of lens 204 is enclosed in the sheath. In another example, the lens may have an outer diameter the same as the outer diameter of the sheath 201. The lens may be fixed to the tip of the first distal end 208 with adhesive. The lens or lens system may be replaced or removed after a period of use to remove any contamination, such as deposition due to ion milling, on the surface of the lens.

FIG. 2B shows relative locations of the light collection system 42 with respect to sample 6 and pole pieces of the ion column 31 and electron column 1. The light collection system can collect photons emitted from sample 6 when being positioned at an imaging position. At the imaging position, the distal end of the light collection system is between the pole piece of a column and the sample in a direction along the optical axis of the column. Photons emitted from the sample will be directly collected by the light collection system 42, without passing or being reflected from any optical component. In one example, the tip of the light collection system is within 2 mm from the eucentric height of the microscopy system. Due to the low profile of the light collection system, the microscopy system can be configured so that the collection angle of the light collection system does not overlap with the collection angles of other detectors (such as the secondary electron detector 212). The light collection system can be used for acquiring light responsive to the electron beam irradiation and/or ion beam irradiation. The light collection system 42 may remain at the same location (e.g. the imaging location) within the vacuum chamber for light collection when switching from one type of charged particle beam irradiation to another type of charged particle beam irradiation during the imaging session. As such, the imaging location is a fixed position in the microscope's coordinate system, and does not change between the electron beam scan and the ion beam scan. Alternatively, the light collection system 42 may be retracted from the imaging location to allow more space for other detectors or sample maneuver. In another embodiment, the imaging position for the electron beam scan and the ion beam scan may be different. For example, the light collection system of the FIB-iLE detector may be adjusted along axis 209 between the electron beam scan and the ion beam scan.

In one example, the sample is tilted to face either the ion column or the electron column for the ion beam scan or the electron beam scan. FIG. 2B shows the sample 6 facing the electron column 1 so that the incidence angle of the electron beam is 90 degrees. In another example, the sample may be positioned at acute angles relative to both the ion-optical axis and the electron-optical axis, so that the sample does not need to be tilted between the ion beam scan and the electron beam scan. The angle between the election-optical axis and the axis 209 of the light detection system is greater than the angle between the ion-optical axis and the axis 209 of the light collection system. This arrangement may achieve high photon collection for both FIB-iLE and cathodoluminescence imaging, because FIB-iLE has more isotropic photon emission comparing to cathodoluminescence.

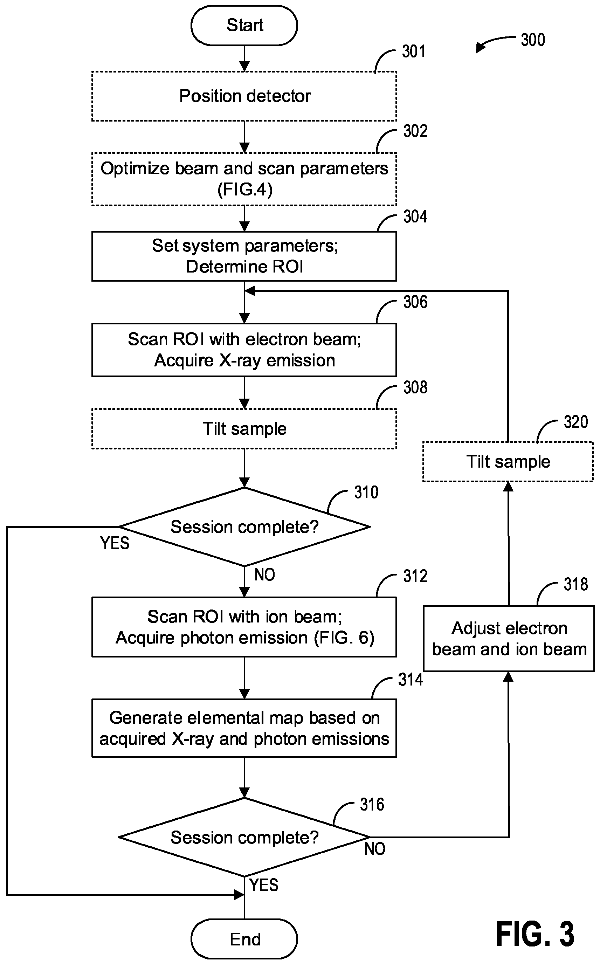

FIG.3 shows method 300 for mapping the elemental composition of a sample using EDS and FIB-iLE. Electron beam scan and ion beam scan are alternatingly performed in a ROI of the sample. X-ray signals acquired during the electron beam scan provide information about the distribution of a first group of elements, and the ion-induced photons acquired during the ion beam scan provide information about the distribution of a second group of elements. By performing the electron beam scan before the ion beam scan, elemental information of the same sample layer can be obtained. During the ion beam scan, the sample layer is removed to expose a new sample surface. By alternating the electron beam scan and ion beam scan, elemental distribution in a sample volume may be mapped.

In one example, the sample may be tilted to face the electron beam or the ion beam between the scans. Each of the charged particle beams may irradiate the sample at 90-degree incidence angle for the scan. In another example, the sample may be held stationary relative to the ion and electron columns during the entire imaging session. Both the electron beam and the ion beam may scan the sample at an incidence angle less than 90 degrees.

At 301, the FIB-iLE detector may optionally be positioned in the vacuum chamber of the charged particle microscope. Positioning the FIB-iLE detector may include inserting the light collection system of the FIB-iLE detector into the vacuum chamber via the flange. Further, the first distal end of the light collection system may be positioned at the imaging position. The vacuum chamber may be pumped down after introducing the light collection system into the vacuum chamber.

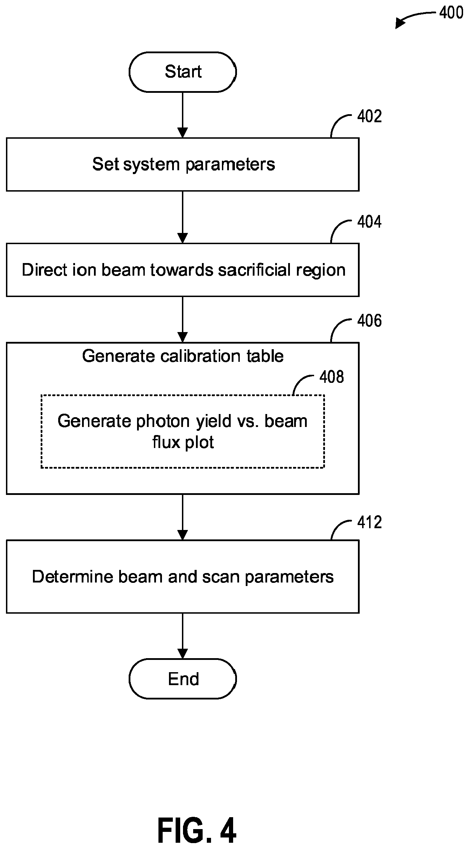

At 302, the beam and scan parameters are optionally determined by performing a parameter optimization procedure on a sacrificial region of the sample or a reference sample. In one example, parameters for the ion beam scan are determined from a calibration table generated based on ion scans on multiple areas in the sacrificial region. Details of the parameter optimization procedure are shown in FIG. 4. In some examples, if the calibration table for the sample type is known, the beam and scan parameters may be determined based on the calibration table.

At 304, system parameters are set for sample imaging. The system parameters may include one or more of beam current, beam size, beam energy, dwell time, integration time of the detector, and scan pattern for both the electron beam and the ion beam. The scan patterns for the electron beam scan and the ion beam scan may be different. The optimal beam and scan parameters determined at 302 may be used for the system parameters. Further, a ROI of the sample (i.e. ROI relative to the sample's coordinates) may be determined. The ROI may be determined based on SEM scans of the sample.

At 306, the ROI is scanned with the electron beam according to parameters set at 304, and X-ray emissions from each scanning location within the ROI are acquired using the EDS detector. During the scan, an image (such as SEM image) showing structural information of the sample surface may also be obtained by detecting backscattered electrons from the sample. In some examples, secondary ion emissions from the sample are acquired for SIMS.

At 308, the sample may optionally be tilted from the electron column towards the ion column.

At 310, method 300 checks whether the imaging session is finished. For example, progress of the image session can be determined based on the SEM image acquired at step 306. If the imaging session is complete, method 300 ends. Otherwise, the ROI is scanned with the ion beam at 312.

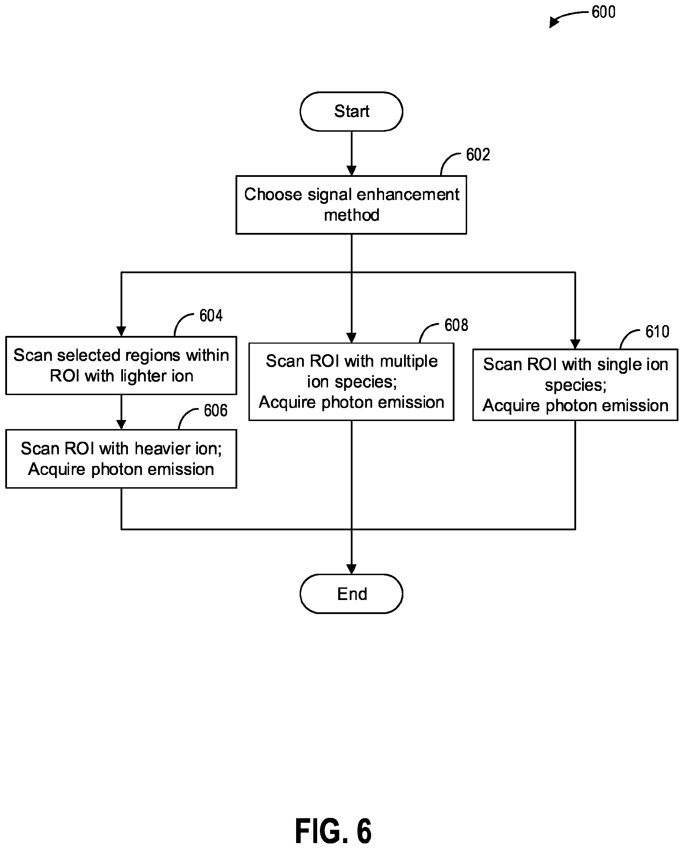

At 312, the ROI is scanned with the ion beam, and photon emissions at each scanning location are acquired using the FIB-iLE detector. The ion beam scan may be adjusted based on the configuration of the microscopy system and the sample type to enhance the FIB-iLE detection. In one example, scanning the ROI with the ion beam includes directing a single species of ions to each of the scanning locations. In another example, scanning the ROI with the ion beam including simultaneously directing ions of at least two species to each of the scanning locations. In yet another example, scanning the ROI with the ion beam including first directing ions of a first species towards each of the scanning locations, and then directing ions of a second species towards each of the scanning locations, wherein the photons are collected responsive to irradiating the sample with the second ion species. Details of the ion beam scan are presented in FIG. 6.

At 314, one or more elemental maps of the sample surface are generated based on the acquired X-ray and photon emissions. The elemental map may show spatial distribution of multiple detected elements within the ROI. Each element may be color-coded differently in the elemental map. Secondary electron (SE) images responsive to the ion irradiation may simultaneously be acquired during the ion scan. The FIB induced SE (FIB-SE) image can show structures of the sample surface. In some examples, the elemental map may be combined with structural image acquired at 306 or the FIB-SE image to display both the structural and compositional information in a single image.

At 316, method 300 checks whether the imaging session is completed. In one example, the progress of the imaging session may be determined based on the structural and/or compositional images generated at step 306 and/or step 314. In another example, imaging session may be complete after reaching a predetermined sample depth or milled a predetermined number of sample layers. If the imaging session is complete, method 300 ends. If the imaging session is not complete, method 300 proceeds to 318 to adjust the electron beam and the ion beam for imaging a sample surface at a greater sample depth. The sample may also optionally be tilted at 320 before being scanned with the electron beam.

In this way, a complete elemental map of one or more sample surfaces/layers can be obtained by scanning the same ROI sequentially with the electron beam and the ion beam in a charged particle microscope. Different elements may be detected by EDS and the FIB-iLE.

In one embodiment, instead of or in addition to acquiring photons responsive to ion irradiation, secondary ions may be acquired for SIMS. The elemental information obtained from SIMS may be combined with the elemental information obtained via FIB-iLE and/or EDS to obtain the complete elemental mapping of the sample. In another embodiment, cathodoluminescence may be collected during the electron beam scan using the FIB-iLE detector.

FIG. 4 shows method 400 for optimizing parameters related to the charged particle beams used in the method of FIG. 3. The parameters may include the ion beam and/or electron beam parameters such as the beam size, beam shape, dwell time, beam energy, beam/stage angle, pitch and overlap between scan locations, and beam resolution. The parameters may also include scan pattern and scan area for each of the electron and ion beams. Method 400 optimizes the ion beam and scan parameters by running a parameter optimization procedure on a sacrificial area of the sample or on a reference sample. During the optimization procedure, one or more of the beam or scan parameters are adjusted to generate one or more calibration tables. The optimal beam and scan parameters may then be selected based on the calibration table.

In one example, optimal parameters for the FIB are determined for enhancing FIB-iLE and/or SIMS image quality. FIB is commonly used for milling a sample. However, the parameters used for FIB milling may not be optimal for FIB-iLE or SIMS. This is because the increased current density and/or the long dwell time used in FIB increase ion implantation and sample damage, but reduce the intrinsic photon or secondary ion yield. During the ion beam scan, the photon or secondary ion yield is affected by composition and structure of the sample, as well as condition of the microscopy system. For example, multiple factors including the matrix effects, preferential sputtering, and ion implantation affect the photon or secondary ion yield. As such, it is extremely difficult or impossible to determine the optimal beam and scan parameters for FIB-iLE or SIMS.

At 402, system parameters for the parameter optimization procedure are set. The system parameters may include one or more of the beam size, beam current, beam energy, dwell time, and scan areas. Further, a sacrificial region may be identified. The sacrificial region may be a sample region not overlapped with the ROI for combined EDS and FIB-iLE imaging. The sacrificial region may alternatively be a region on a reference sample.

At 404, the ion beam is directed towards an area in the sacrificial region.

At 406, one or more areas in the sacrificial region are irradiated using different beam or scan parameters of the ion beam, and photon and/or secondary electron yield is recorded. The calibration table may be generated based on the recorded yields at their corresponding beam/or scan parameters. In one example, generating the calibration table includes generating a photon yield versus beam flux plot at 408. Multiple calibration tables may be generated for various ion beam accelerating energies due to the change in implantation, damage, and sputtering rate at different energies. The generated calibration table(s) may be saved for determining the parameters in future imaging sessions.

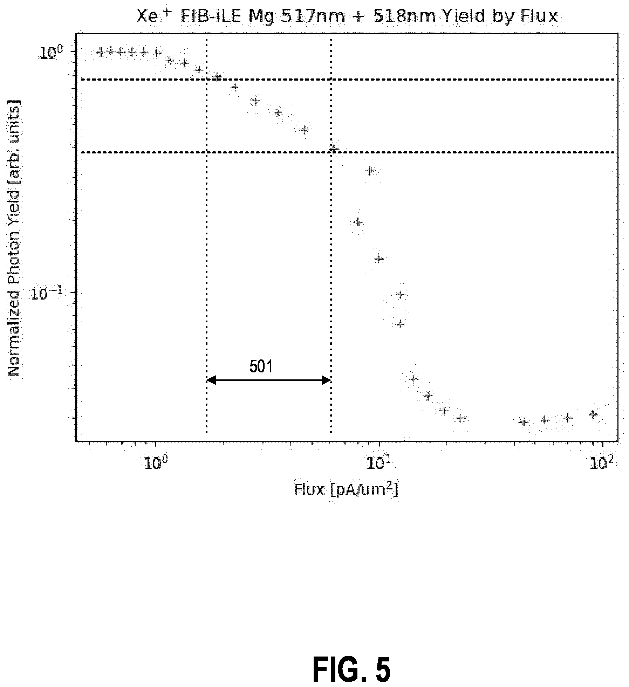

One example calibration table is a photon yield versus beam flux plot shown in FIG. 5, wherein photon yield is recorded at each of the multiple ion beam flux. Normalized photon yield is shown in FIG. 5. The multiple beam flux can be obtained by adjusting one or more of the scan area, beam spot size, and the beam current. In one example, the beam flux is adjusted by adjusting the scan area while maintaining the same beam current and spot size. The value of the beam flux is calculated as the averaged beam current in the scanned area. Multiple scan areas of different sizes in the sacrificial region are repetitively scanned using the same beam parameters. The scan parameters, except for the scan area, remain the same. While repetitively scanning each of the scan areas, the photon yield of one or more elements is monitored. When the photon yield change is within a predetermined yield change range (such as within 10% of the maximum photon yield), the steady-state photon yield corresponding to the scan area is recorded. In another example, the beam flux is adjusted by adjusting the beam spot size while maintaining the beam current. The photon yield of one or more elements is monitored while decreasing the beam spot size to obtain the multiple beam flux. The value of the beam flux is calculated as the beam current divided by the beam spot size. The beam spot size may be adjusted by adjusting the focusing lens. In yet another example, the beam flux is adjusted by adjusting the beam current while maintaining the scan area and/or the beam spot size. The beam current may be adjusted by adjusting the ion beam apertures and/or the focusing lens.

FIG. 5 shows an example photon yield versus ion beam flux plot generated using a reference sample containing Mg with the 30 keV Xe⁺ beam. The steady-state photon yield for Mg at 517 nm and 518 nm wavelengths were recorded at ion beam flux ranging from 0.5 pA/um² to 100 pA/um². The photon yield decreases with the increased flux. This decrease reflexes the oxygen replenishment rate from native vacuum chamber water vapor at the sacrificial region. As the beam flux increases, the oxygen replenishment rate decreases. This means that at higher beam flux, the sample surface does not have sufficient time to be oxidized, therefore the photon yield is reduced.

In some example, plot similar to FIG. 5 may be generated for SIMS. In some example, different calibration tables may be generated for different element or component.

At 412, the beam and scan parameters that are optimal for the FIB-iLE and/or SIMS imaging are selected based on the calibration table. For example, beam and scan parameters corresponding to the ion beam flux within range 501 of FIG. 5 are selected for the ion beam scan. Ion beam scan with the optimal beam and scan parameters can obtain strong FIB-iLE signal with relatively high sputtering rate. Parameters corresponding to the highest photon yield are not selected because they may lead to increased total scan time.

In some examples, a trained neural network (NN) may be used to determine the optimal beam and scan parameters from calibration data collected in a sacrificial region. The NN may be trained with training data generated through finding the optimal imaging conditions for a sample type. For example, the training data may consist of photon yield as function of ion dose to a sample area, similar to the plot shown in FIG. 5. The optimal beam and scan parameters predicted by the NN will account for surface conditions which change during milling in order to maximize FIB-iLE signal while minimizing acquisition time. In addition to optimize the parameters before analyzing the sample, the NN may also be used to optimize the parameters during the imaging session, based on the received light signal. Machine learning techniques such as deep NN and convolutional NN may be used for optimizing the beam and scan parameter.

FIG. 6 shows method 600 for performing ion beam scan for enhanced photon and/or secondary ion yield. The yield of photon or secondary ion responsive to FIB bombardments can be enhanced by adjusting the chemistry of the ion beam. For example, ions of different gas species may be used for the ion beam scan.

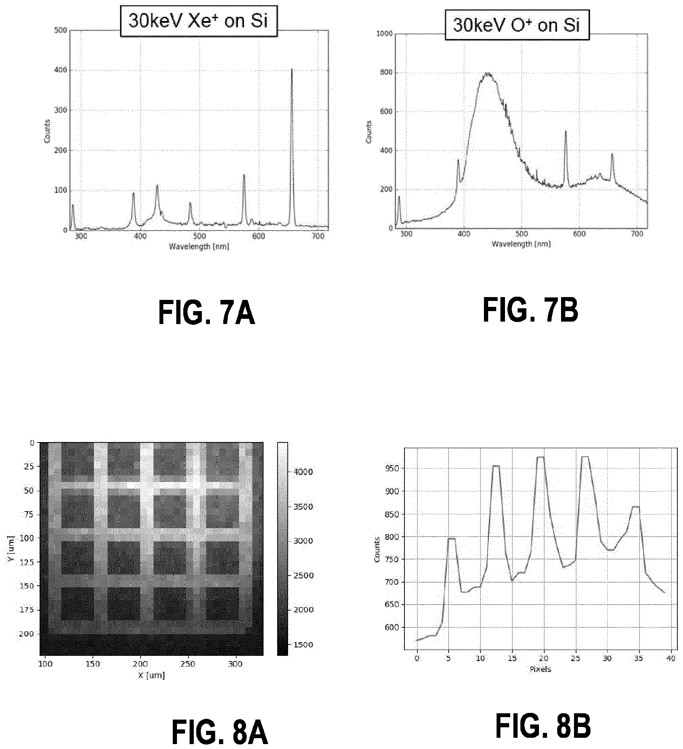

Different ions interact with the sample differently. For example, heavy ions (i.e. ions with atomic weight greater than 11), such as Xe⁺, have smaller interaction volumes in the sample and promote sputtering. Signals generated from heavy ions contain mainly elemental line emission. Light ions (i.e. ions with atomic weight not greater than 11), such as He⁺ and O⁺, have larger interaction volumes in the sample and promote electron-hole recombination. Signals generated from light ions contain band-gap and crystal information. FIG. 7A shows photon emissions in the form of a spectrum from a silicon sample responsive to 30 KeV Xe⁺ irradiation. FIG. 7B shows photon emissions from the same sample responsive to 30 KeV O⁺ irradiation. FIG. 7A contains mainly elemental mission lines from Si with little broadband ionoluminescence emission comparing to FIG. 7B. FIG. 7B contain mainly broadband ionoluminescence from electron-hole recombination. By adjusting the ion species used for the ion beam scan, FIB-iLE and/or SIM signals can be enhanced.

At 602, signal enhancement method for the ion beam scan is selected based on one or more of sample composition, sample property, and parameters of the microscope. For example, the signal enhancement method may be selected based on one or more of the materials of the sample, the oxygen replenishment rate of the sample within the vacuum chamber of the microscope, and requirements of the sample analysis. The oxygen replenishment rate may be determined at 302 of FIG. 3. Further, the signal enhancement method may also be selected based on previous experimental knowledge. The signal enhancement methods may include A) scanning the sample surface sequentially with light ions and heavy ions (604 and 606), B) scanning the sample surface using an ion beam including at least two ion species (608), and C) scanning the sample surface using an ion beam including a single ion species (610). In one example, method A) may be selected for direct write and localized signal enhancement of the ROI. Method B) may be selected for global signal enhancement, and improving the planar delayering of the ion beam scan. Methods B) or C) may be selected for decreasing the total imaging session duration and/or maximum possible sputtering/removal. Method C) may be selected for minimizing the sample damage and least chemical altering to the sample.

At 604, selected regions within the ROI are scanned first with a lighter, more active, ion type to precondition the sample surface by implanting the lighter ions. The regions within ROI may be selected based on the SEM image collected during the electron beam scan at 306. Then, at 606, the ion source is switched from the lighter ion type to a heavier, more inert, ion type to scan the entire ROI. Photon emissions are acquired during the scan using heavier ions. In one example, the atomic number difference between the lighter and heavier ions is greater than 10. By implanting light ions in one or more sub-areas of the ROI, FIB-iLE signals in these selected regions may be enhanced. The selected regions may include elements having lower photon yield. By selectively enhancing FIB-iLE signals within these regions, the signal-to-noise ratio of the entire ROI can be improved in the FIB-iLE image acquired at 606. Further, by limiting regions for light ion implantation, sample damage and/or chemical altering of the sample surface may be minimized. In some embodiments, at 606, additionally, or alternatively, to acquiring photon emissions, secondary ions may be acquired during the scan using heavier ions.

FIG. 8A and FIG. 8B demonstrate enhanced photon emission after oxygen implantation. After irradiating a Be sample surface with O⁺ ion beam according to a grid pattern, the sample surface was scanned with 30KeV Xe⁺ beam and photon emissions were acquired. FIG. 8A shows signal strength at Be emission lines (333 nm and 457 nm wavelengths) at each scanning location. The grid pattern with oxygen implantation can be seen, indicating that the lighter ion implantation enhanced the FIB-iLE signals acquired in the subsequent ion beam scan using heavier ions. FIG. 8B shows signals integrated along Y-axis of FIG. 8A.

At 608, the photons are acquired responsive to scanning the ROI with an ion beam including at least two ion species. Different from 604 and 606, wherein the sample surface is first scanned with a lighter ion species then a heavier ion species, herein, ions of multiple species are simultaneously directed to the sample surface. In one example, the ion beam includes a lighter ion species and a heavier ion species. The atomic weight difference between the two ion species may be not less than 8, 10, or 20. The acquired photon emissions include both narrow band elemental line emission from light ion bombardment and broadband electron-hole recombination from heavy ion bombardment. By irradiating the sample surface simultaneously with both light and heavy ions, the FIB-iLE and/or SIMS signals are enhanced while maintaining minimal reduction to the sputtering rate. Comparing to the ion beam scan using only the heavy ion, the FIB-iLE and/or SIMS signal is stronger. Comparing to the ion beam scan using only the light ion, the delayering (or sputtering) rate is higher.

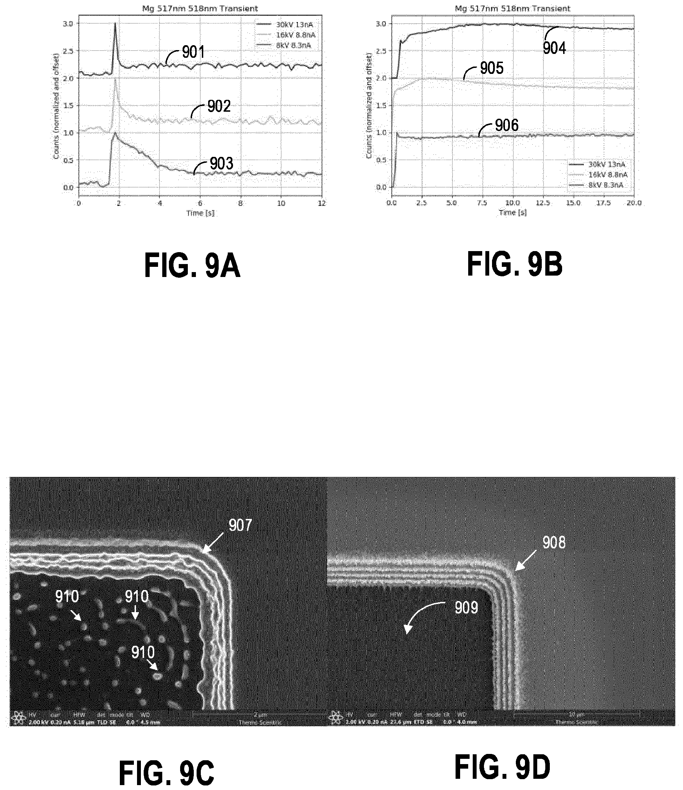

FIG. 9A and FIG. 9B show FIB-iLE signal strength at Mg emission lines (517 nm and 518 nm wavelength) over time while a sample area was repetitively irradiated with ion beam of only Xe⁺ (FIG. 9A) or only O⁺(FIG. 9B). To generate each figure, the sample area was scanned using different beam conditions: 30KeV 13nA (901 and 904), 16KeV 8.8nA (902 and 905), and 8KeV 8.3 nA (903 and 906). The signal amplitudes for different beam conditions are normalized and offset in each figure. In FIG. 9A, for all beam conditions, the FIB-iLE signal amplitude peaks when the ion beam started bombarding the sample at around 1.6 second, and then decreases over time. The signal amplitude corresponding to higher beam energy and higher beam current decreases faster over time. In FIG. 9B, for all beam conditions, after peaking at onset of the ion beam, the FIB-iLE signal amplitude remained high as the sample was repetitively scanned by the ion beam. The different signal behaver between FIG. 9A and FIG. 9B is because when the ion beam contains only the Xe⁺, the native oxide layer of the sample surface was sputtered away quickly and there is little time to replenish the newly exposed sample surface with oxygen, which results a rapid decay of the photon yield in FIG. 9A. Higher beam energy and beam current lead to more rapid photon yield decay. However, for ion beam containing only O⁺, the newly exposed sample surface is continually replenished with the oxygen provided by the ion beam. Therefore, the signal amplitude remains high over time.

FIG. 9C and FIG. 9D show SEM images of the side walls 907 and 908 of a box mill, using only 30 KeV Xe⁺ (FIG. 9C) and only 30 KeV O⁺ (FIG. 9D), on a sample with alternating layers of Nickel and Chromium. Comparing to FIG. 9C, in FIG. 9D, the ion beam with light ions resulted with a more planar delaying surface 909, absent of chromium islands 910 in FIG. 9C.

At 610, photons are acquired responsive to irradiating the sample with ion beam of a single ion type.

In this way, the FIB-iLE signals may be enhanced by using ions or multiple gas species. The SIMS signals may be enhanced via the same process.

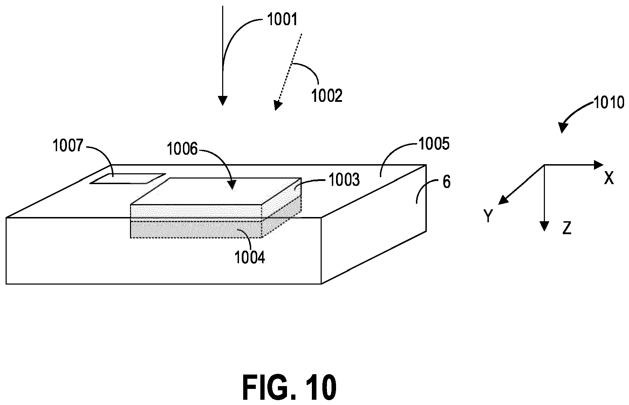

FIG. 10 illustrates sample 6 analyzed by method 300 of FIG. 3. Coordinate 1010 is sample coordinate, different from microscope coordinate (110 of FIG. 1). Sample 6 may be irradiated with charged particle beam along direction 1001, wherein the sample is tilted to face each of the charged particle beams during the imaging session. Alternatively, sample 6 may be irradiated with charged particle beam along direction 1002, wherein the sample is not tilted when switching between the charged particle beams. The sample is positioned in the X-Y plan, with sample depth increasing along the Z axis. The ROI 1006 for ion beam and electron beam scan is defined with the X and Y axes in the sample coordinate. Region 1007 may be a sacrificial region for performing the parameter optimization procedure of FIG. 6. After scanning the ROI with the electron beam and the ion beam, a first layer 1003 of the sample is sputtered away by the ion beam scan. Distribution of elements in the first layer may be analyzed using acquired X-ray and photon emissions. Then, the ROI may be scanned again using the electron beam and the ion beam. A second layer 1004 of the sample is sputtered away, and elemental mapping can be formed for the second layer using the acquired X-ray and photon emissions. The second layer is at a greater sample depth comparing to the first layer.

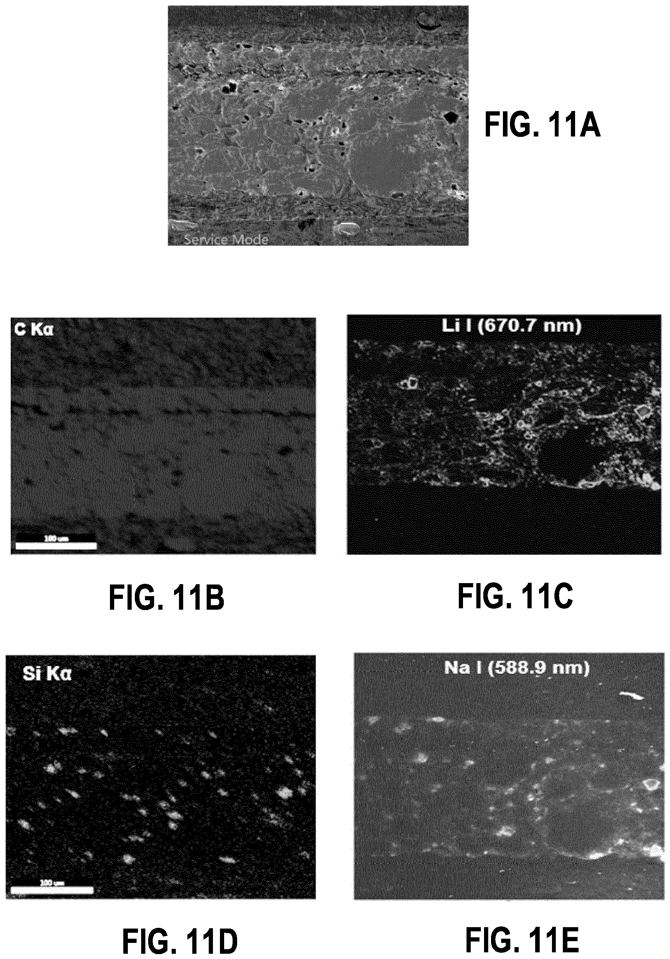

FIGS. 11A-11E are cross-sectional images of a Si-C anode sample obtained using the microscopy system of FIG. 1. FIG. 11A is a SEM image generated with secondary electrons acquired during the electron beam scan. FIG. 11B and FIG. 11D are EDS images generated with X-ray emissions acquired during the electron beam scan. FIG. 11B shows the distribution of C and FIG. 11D shows the distribution of Si. FIG. 11C and FIG. 11E are FIB-iLE images generated from photon emissions acquired during the ion beam scan. FIG. 11C and FIG. 11E show the distribution of Li and Na, respectively. Li and Na cannot be detected by EDS. Due to different sensitivities of EDS and FIB-iLE to different elements, a complete elemental mapping of the battery sample can be obtained.

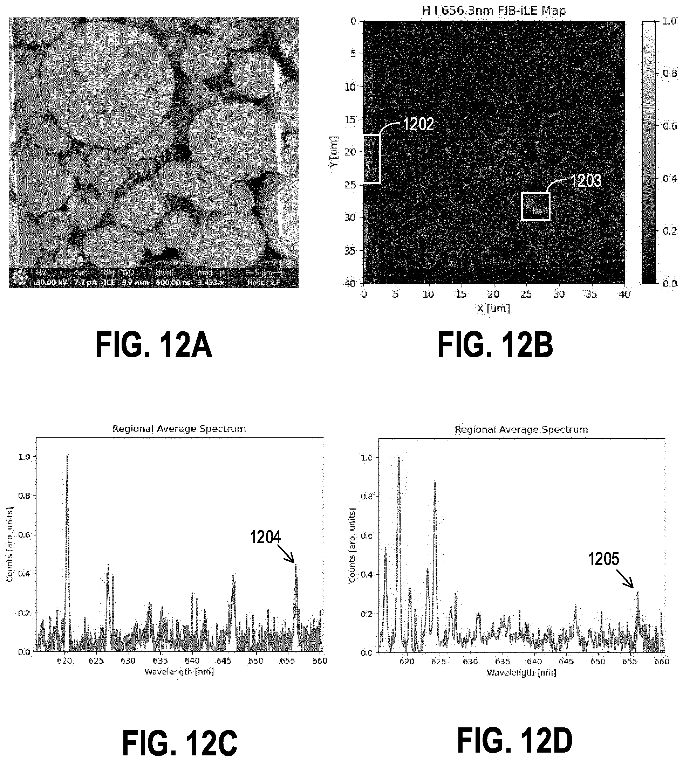

FIGS. 12A-12B are FIB-SE and FIB-iLE images of a cross-section of a Lithium ion battery cathode sample. Distribution of H, which cannot be imaged with EDS or SIMS, can be seen in FIB-iLE image FIG. 12B generated with FIB-iLE signals at H emission line (656.3 nm wavelength). FIG. 12C and FIG. 12D are integrated spectrum corresponding to region 1202 and region 1203 of FIG. 12B, respectively. Photon emission from H at 656.3 nm wavelength was obvious as indicated by arrows 1204 and 1205.

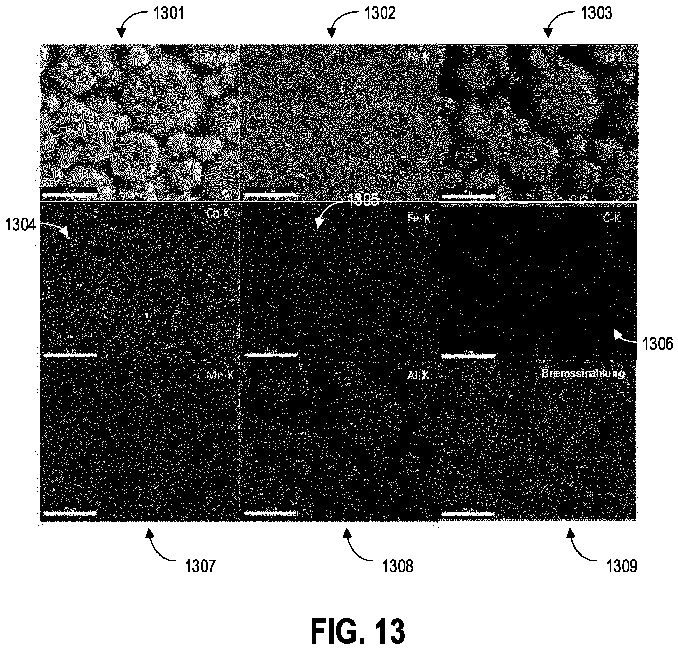

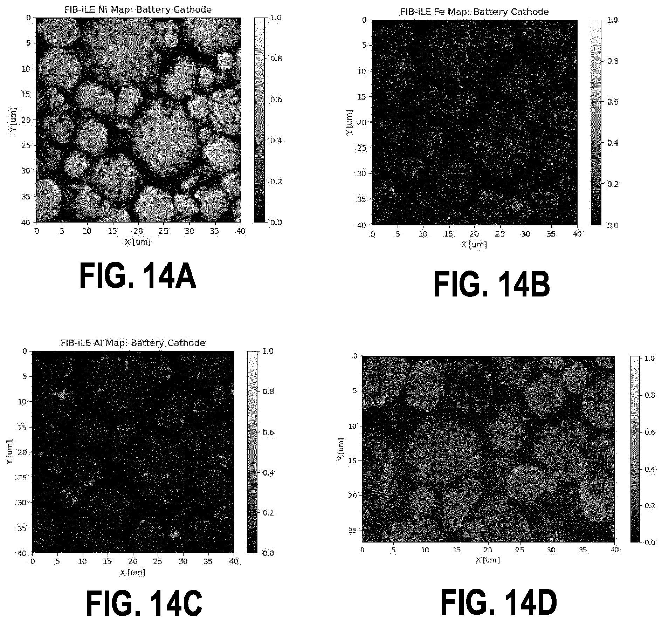

FIG. 13 is a collage of SEM and EDS images of a Nickel Manganese Cobalt (NMC) cathode sample collected during an electron beam scan. SEM image 1302 shows the structure of the sample surface. EDS images 1302-1308 shows the spatial distributions of Ni, O, Co, Fe, C, Mn, and Al. Image 3019 shows the Bremsstrahlung radiation. FIGS. 14A-14D shows the FIB-iLE images of Ni, Fe, Al, and Li acquired from the same sample as shown in FIG. 13. EDS images of Ni, Fe, and Al (1302, 1305 and 1308 of FIG. 13) mainly show Bremsstrahlung radiation, while the distributions of these elements are clearly shown in the FIB-iLE images (FIGS. 14A-14C).

The technical effect of performing the electron beam scan before the ion beam scan is that elements in the same sample layer can be analyzed. Further, a complete elemental map can be generated due to different sensitivities of FIB-iLE and EDS to different elements. The technical effect of optimizing the ion beam before the imaging session is to obtain high FIB-iLE signal at a desired sample sputtering rate. The technical effect of using the retractable light collection system for FIB-iLE imaging is that the light collection system can stay at the imaging position when switching the charged particle beams. Further, the retractable light collection system can be used a conventional dual-beam system. The technical effect of using multiple ion species together or sequentially during the ion beam scan is that the FIB-iLE signals are enhanced.

In one presentation, a light collection system for collecting light in response to charged particle irradiation, comprises an optical fiber with a first distal end enclosed in an elongated sheath; a lens positioned at a first distal end of the light collection system, wherein the lens is optically coupled with the optical fiber for directly collecting light emitted from a sample responsive to the charged particle irradiation, and the lens is mechanically coupled to the sheath, and wherein the light collection system is retractable from an imaging position located proximate to a sample, the sample positioned on a sample stage in a vacuum chamber. In a first example of the system, the first distal end of the light collection system can be retracted from the imaging position wherein the first distal end of the light collection system positioned between a pole piece and the sample while in the imaging position. A second example of the system optionally includes the first example and further includes wherein the light collection system is retractable from the vacuum chamber via a flange. A third example of the system optionally includes one or more of the first to the second examples, and further includes wherein the diameter of the lens is equal or less than the diameter of the sheath. A fourth example of the system optionally includes one or more of the first to the third examples, and further includes wherein at least part of the lens is enclosed by the sheath. A fifth example of the system optionally includes one or more of the first to the fourth examples, and further includes wherein the lens includes multiple lenses of the same diameter. A sixth example of the system optionally includes one or more of the first to the fifth examples, and further includes wherein the lens focuses the beam into the optical fiber. A seventh example of the system optionally includes one or more of the first to the sixth examples, and further includes wherein the lens is fused with the first distal end of fiber. An eighth example of the system optionally includes one or more of the first to the seventh examples, and further includes wherein the lens is spaced from the first distal end of fiber, and the sheath has at least one opening fluidically connecting the vacuum chamber and the space between the fiber and the lens within the sheath. A ninth example of the system optionally includes one or more of the first to the eighth examples, and further includes wherein the lens is removable from the light collection system.

In another representation, a charged particle microscopy system includes an electron column, an ion column, and a detector for collecting photons generated in response to electron irradiation and/or ion irradiation. In a first example of the system, the detector includes a retractable light collection system. A second example of the system optionally includes the first example and further includes a vacuum chamber, wherein the light collection system can be retractably removed from the vacuum chamber via an opening on the vacuum chamber. A third example of the system optionally includes one or more of the first to the second examples, and further includes a GIS system, wherein the GIS system can be introduced into and removed from the opening on the vacuum chamber. A fourth example of the system optionally includes one or more of the first to the third examples, and further includes wherein the light collection system collects photons at an imaging position, and the collection angle of the light collection system at the imaging position does not overlap with the collection angle of other detectors of the microscopy system.

In yet another presentation, a method for collecting light emitted from a sample using a light detection system comprises, before pumping down a vacuum chamber within which the sample is positioned, inserting the light collection system via an opening on the vacuum chamber; irradiate the sample with charged particle beam or photon and receiving photons emitted from sample responsive to the irradiation with a first distal end of the light collection system at an imaging position. In a first example of the method, further includes monitoring signal attenuation over time and changing or cleaning a lens in the light collection system. A second example of the method optionally includes the first example and further includes delivering light towards the sample using the light collection system.

## Claims

1. A method of imaging a sample with a charged particle microscope, comprising:
scanning a region of interest (ROI) of a sample with an electron beam and acquiring X-rays emitted from the sample;
after scanning the ROI with the electron beam, scanning the ROI with an ion beam and acquiring ion-induced photons emitted from the sample; and
determining a spatial distribution of multiple elements in the sample based on both the acquired X-rays and the acquired ion-induced photons.

2. The method of claim 1, wherein determining a spatial distribution of multiple elements includes determining the spatial distribution of at least one element with an atomic number greater than 11 based on the acquired X-rays, and determining the spatial distribution of at least one element with an atomic number not greater than 11 based on the acquired ion-induced photons.

3. The method of claim 1, wherein determining a spatial distribution of multiple elements includes determining the spatial distribution of at least one element of alkali metal based on the acquired ion-induced photons, and determining the spatial distribution of at least one element not belonging to the alkali metal based on the acquired X-rays

4. The method of claim 1, wherein determining a spatial distribution of multiple elements includes determining the spatial distribution of at least an element with a higher weight concentration based on the acquired X-rays, and determining the spatial distribution of at least an element with a lower weight concentration based on the acquired ion-induced photons.

5. The method of any of claims 1-4, further comprising tilting the sample after scanning the ROI with the electron beam and before scanning the ROI with the ion beam.

6. The method of any of claims 1-4, wherein the sample is not tilted between scanning the ROI with the electron beam and scanning the ROI with the ion beam.

7. The method of claim 6, wherein an incidence angle of the electron beam is the same as an incidence angle of the ion beam.

8. The method of any of claims 1-7, wherein acquiring ion-induced photons emitted from the sample includes acquiring the ion-induced photons with a light collection system positioned at an imaging position, and wherein the light collection system is retractable from the imaging position.

9. The method of claim 8, wherein a first distal end of the light collection system is positioned between a pole piece and the sample when the light collection system is positioned at the imaging position.

10. The method of claims 8 or 9, wherein at the imaging position, a collection angle of the light collection system does not overlap with a collection angle of a detector for acquiring the X-rays.

11. The method of any of claims 1-10, further comprising:
after scanning the ROI with the ion beam, scanning the ROI with the electron beam and acquiring X-rays emitted from the sample at a second sample depth;
scanning the ROI with the ion beam and acquiring ion-induced photons emitted from the sample at the second sample depth; and
determining the spatial distribution of multiple elements based on both the acquired X-rays and the acquired ion-induced photons at the second sample depth.

12. The method of any of claims 1-11, wherein the ion beam includes ions of at least two species.

13. The method of any of claims 1-12, further comprising determining one or more ion beam parameters and scan parameters before scanning the ROI with the ion beam.

14. The method of claim 13, wherein the one or more ion beam parameters and scan parameters are determined based on data collected by irradiating a sacrificial region.

15. The method of claim 13, wherein the one or more ion beam parameters and scan parameters are determined using a trained neural network.

16. The method of claim 1, wherein scanning the ROI with the ion beam includes scanning one or more selected regions within the ROI with an ion beam of a first ion species and then scanning the ROI with a second ion beam of a second ion species, wherein an atomic number of the first ion species is lower than an atomic number of the second ion species.

17. A charged particle microscopy system for determining composition of a sample, comprises:
an ion source for generating an ion beam;
an electron source for generating an electron beam;
a first detector for detecting X-rays emitted from a sample;
a second detector for detecting ion-induced photons emitted from the sample;
a controller including a non-transitory memory for storing computer readable instructions, wherein by executing the instructions, the controller is configured to:
scan a region of interest (ROI) of the sample with the electron beam and acquire X-rays emitted from the sample using the first detector;
after scanning the ROI with the electron beam, scan the ROI with the ion beam and acquire ion-induced photons emitted from the sample using the second detector; and
determine a spatial distribution of multiple elements in the sample based on both the acquired X-rays and the acquired ion-induced photons.

18. The charged particle microscopy system of claim 17, further comprising a pole piece through which the ion beam is directed to the sample, the second detector includes a retractable light collection system, wherein acquiring ion-induced photons emitted from the sample using the second detector includes acquiring ion-induced photons entering a first distal end of the light collection system positioned between the pole piece and the sample.

19. The charged particle microscopy system of claim 18, further comprising a vacuum chamber, wherein the sample is positioned within the vacuum chamber, and the light collection system can be retractably removed out of the vacuum chamber via a flange on the vacuum chamber.

20. The charged particle microscopy system of claim 19, further comprising a gas injection system (GIS), and the GIS can be introduced and removed from the vacuum chamber via the flange.
